# EUROPEAN PATENT SPECIFICATION

(11) **EP 1 771 060 B1**
(45) Date of publication and mention of the grant of the patent: **21.11.2012**
(21) Application number: 06020543.2
(22) Date of filing: 29.09.2006
(51) Int. Cl.: H05K 13/04, H05K 13/08

(54) **Electronic component mounting apparatus**
Einrichtung zur Montage von elektronischen Bauteilen
Dispositif de montage de composants électroniques

(30) Priority: 30.09.2005 JP 2005287152
(43) Date of publication of application: 04.04.2007
(60) Divisional application: 10010899.2
(73) Proprietor: Hitachi High-Tech Instruments Co., Ltd., Ora-gun, Gunma-ken, 370-0596 (JP)
(72) Inventor: Ieizumi, Kazuyoshi, Gunma 373-0813 (JP); Kameda, Makio, Gunma 373-0808 (JP); Fukushima, Yoshiharu, Gunma 370-0514 (JP); Kashitani, Hisayoshi, Gunma 373-0806 (JP)
(74) Representative: Glawe, Delfs, Moll

(56) References cited:
- EP-A2- 1 189 497
- US-A- 5 339 248
- US-A1- 2004 168 310

## Description

### BACKGROUND OF THE INVENTION

### Field of the Invention:

The invention relates to an electronic component mounting apparatus having a component feeding unit supplying an electronic component to a component pickup position, a vertically movable suction nozzle picking the electronic component up from this component feeding unit and mounting the electronic component on a printed board, and X and Y axes as horizontal axes moving this suction nozzle in the horizontal direction.

### Description of the Related Art:

This kind of electronic component mounting apparatus has been known well as described, for example, in Japanese Patent Application Publication No. 2001-156498. When an electronic component supplied from the component feeding unit is to be picked by suction by the suction nozzle or when the picked electronic component is to be mounted on the printed board, the suction nozzle is moved in the horizontal direction to above the component feeding unit or to above the printed board, then lowered to pick the electronic component up or mount the electronic component on the board, moved upward, and further moved in the horizontal direction to above the printed board or to above the component feeding unit.

US-2004/0168310 discloses an electronic component mounting apparatus that moves an XY robot attached with a plurality of suction nozzles horizontally on an XY plane which moving the suction nozzles vertically.

There is a case where the horizontal movement and the vertical movement of the suction nozzle are performed simultaneously when the electronic component is to be picked up from the component feeding unit or to be mounted on the printed board in order to reduce mounting time from the time when the suction nozzle is lowered to complete the pickup operation and the mounting operation of the electronic component until the time when the suction nozzle is moved upward, that is, so-called takt time. When the horizontal movement and the vertical movement of the suction nozzle are to be performed simultaneously for picking the electronic component up from the component feeding unit or for mounting the electronic component on the printed board, timing to start the lowering of the suction nozzle during its movement in the horizontal direction and timing to start the movement of the suction nozzle in the horizontal direction during its rising when the electronic component is to be picked up or mounted are controlled so as to avoid the contact of the lower surface of the suction nozzle or the electronic component held by the suction nozzle and the component feeding unit or an electronic component already mounted on the printed board.

However, start delay of the vertical movement mechanism or the horizontal axes of the suction nozzle delays the timing to start the lowering of the suction nozzle during its movement in the horizontal direction or the timing to start the movement of the suction nozzle in the horizontal direction during its rising when the electronic component is to be picked up or mounted. Furthermore, although the vertical movement speed of the suction nozzle is increased depending on the types of the electronic components, the timings are not changed. As a result of this, there is a problem of increasing the takt time. It is an object of this invention to lessen this drawback.

### SUMMARY OF THE INVENTION

The solution according to the invention lies in the features of the independent claims and preferably in those of the dependent claims. The invention is directed to minimization of mounting time (takt time) of each of electronic components when an electronic component is picked up from a component feeding unit or mounted on a printed board.

The invention provides an electronic component mounting apparatus including: a component feeding unit supplying an electronic component; a suction nozzle picking the electronic component supplied from the component feeding unit by suction; a horizontal axis moving the suction nozzle in a horizontal direction; a vertical movement mechanism vertically moving the suction nozzle; and a control device starting the horizontal axis based on a rising speed of the suction nozzle and start delay time of the horizontal axis after the electronic component is picked by suction by the suction nozzle or after the electronic component picked by suction by the suction nozzle is mounted on a printed board.

The invention also provides an electronic component mounting apparatus including: a component feeding unit supplying an electronic component; a suction nozzle picking the electronic component supplied from the component feeding unit by suction; a horizontal axis moving the suction nozzle in a horizontal direction; a vertical movement mechanism vertically moving the suction nozzle; and a control device calculating a contact avoiding position of the suction nozzle where the suction nozzle or the electronic component held by suction by the suction nozzle does not contact the component feeding unit or an electronic component on the printed board, calculating lowering time until the suction nozzle lowers to the contact avoiding position, calculating a first distance of horizontal movement of the horizontal axis during the lowering time, and starting lowering of the suction nozzle when the horizontal axis reaches a position that is at the first distance behind a position where the electronic component is to be picked or mounted.

In the invention, the simultaneous movement of the suction nozzle in the vertical direction and the horizontal direction can be started as early as possible based on the start delay of the vertical movement mechanism or the horizontal axes of the suction nozzle, and thus the mounting time of each of the electronic components can be minimized.

### BRIEF DESCRIPTION OF THE DRAWINGS

Fig. 1 is a plan view of an electronic component mounting apparatus.
Fig. 2 is a front view of the electronic component mounting apparatus.
Fig. 3 is a right side view of the electronic component mounting apparatus.
Fig. 4 is a control block diagram of the electronic component mounting apparatus.
Fig. 5 is a longitudinal cross-sectional view of a front of a mounting head body.
Fig. 6 is a longitudinal cross-sectional view of a side of the mounting head body.
Fig. 7 is a plan view of a fixing support piece and a vertical movement support piece.
Fig. 8 is a schematic bottom view of the mounting head.

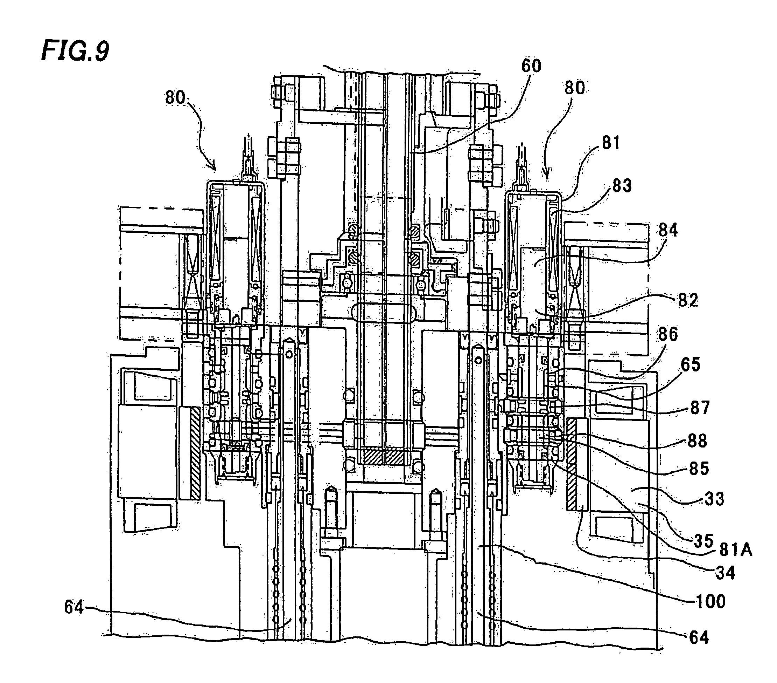

Fig. 9 is an enlarged longitudinal cross-sectional view of a lower portion of a front of the mounting head.
Fig. 10 is a view showing an operation screen displayed on a monitor.
Fig. 11 is a flow chart.
Fig. 12 is a table showing mounting data.
Fig. 13 is a table showing component disposition data.
Fig. 14 is a table showing component library data where component ID is C0402.
Fig. 15 is a table showing component library data where component ID is C0603.
Fig. 16 is a table showing component library data where component ID is R0603.
Fig. 17 is a flow chart.
Fig. 18 shows a vertical movement of the suction nozzle of one embodiment of this invention.
Fig. 19 shows a vertical movement of the suction nozzle of another embodiment of this invention.

### DETAILED DESCRIPTION OF THE INVENTION

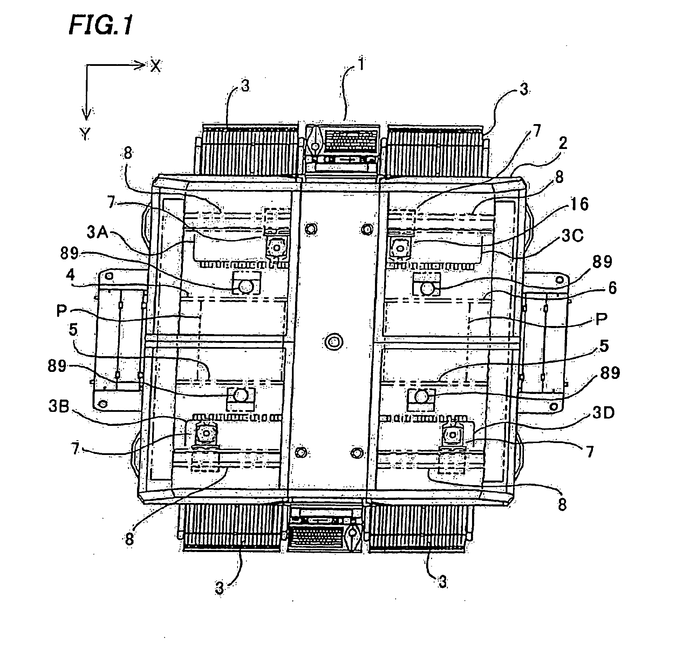

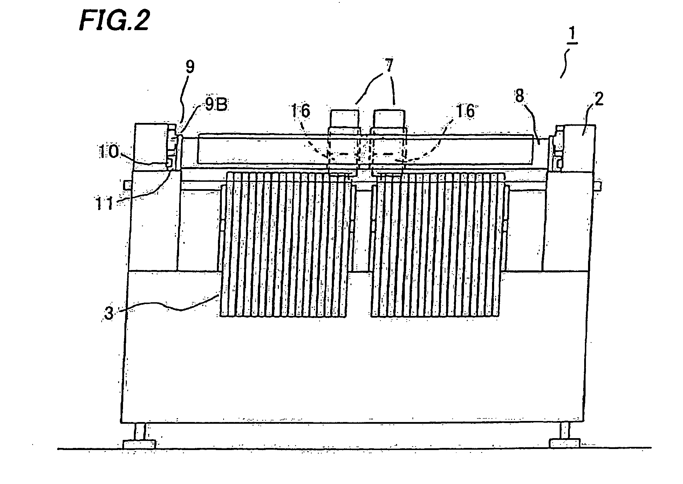

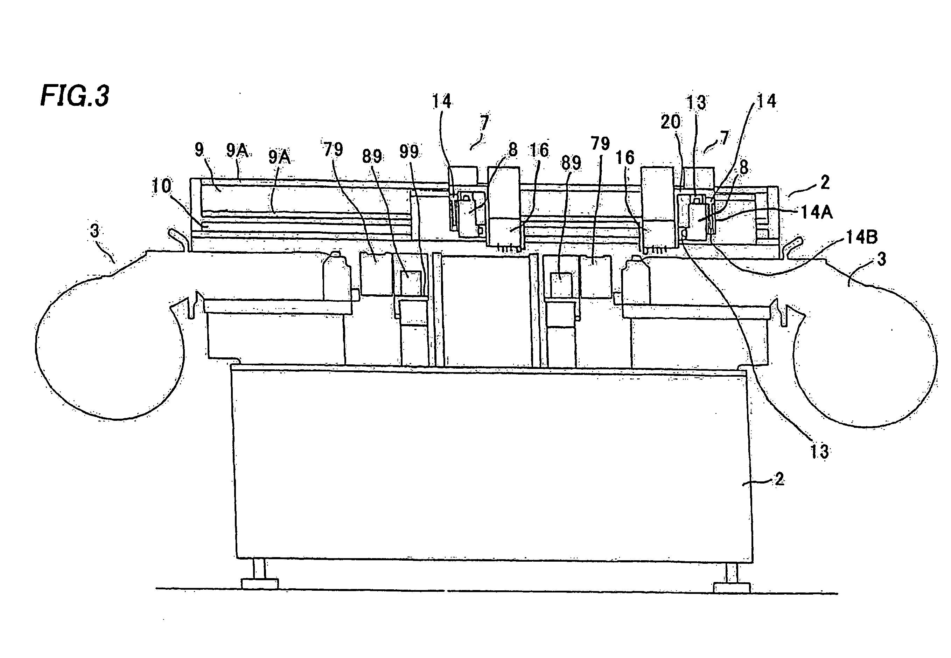

An embodiment of an electronic component mounting apparatus of the invention will be described with reference to the drawings. Fig. 1 is a plan view of an electronic component mounting apparatus 1, Fig. 2 is a front view of the electronic component mounting apparatus 1, and Fig. 3 is a right side view of the electronic component mounting apparatus 1. A plurality of component feeding units 3 for feeding a variety of electronic components one by one to each of component feeding positions (component pickup positions) is attachably and detachably aligned and fixed on feeder bases 3A, 3B, 3C, and 3D on a base 2 in the apparatus 1. A feed conveyer 4, a positioning portion 5, and a discharge conveyer 6 are provided between groups of the units 3 facing to each other. The feed conveyer 4 conveys a printed board P received from an upstream to the positioning portion 5, an electronic component is mounted on the printed board P positioned by a positioning device (not shown) in the positioning portion 5, and the printed board P is conveyed to the discharge conveyer 6.

A numeral 8 designates a pair of front and rear beams extending in an X direction provided on left and right portions of the mounting apparatus 1 respectively. Each of the beams 8 respectively moves in a Y direction above the printed board P on the positioning portion 5 or the component feeding positions (component pickup positions) of the component feeding units 3 as sliders 11 fixed to each of the beams 8 slide along a pair of left and right guides 10, driven by each of linear motors 9.

Each of the linear motors 9 has a pair of upper and lower stationary members 9A fixed on the base 2 and a moving member 9B fixed to a lower part of an attachment board provided on each end of the beam 8.

Each of the beams 8 is provided with a mounting head body 7 which moves in a longitudinal direction, i.e., in the X direction along a guide 13 driven by the linear motor 14 and forms an X axis and Y axis as horizontal axes together with the beams 8. The linear motor 14 has a pair of front and back stationary members 14A fixed to the beam 8 and a moving member 14B provided on the mounting head body 7 and between the stationary members 14A.

Each of the mounting head bodies 7 has a mounting head 16 having twelve suction nozzles 15 each fixed to and pulled down by each of twelve springs 12. A board recognition camera 19 is provided on the mounting head 16 in each of the mounting head bodies 7 and takes an image of a positioning mark (not shown) on the printed board P positioned on the positioning portion 5.

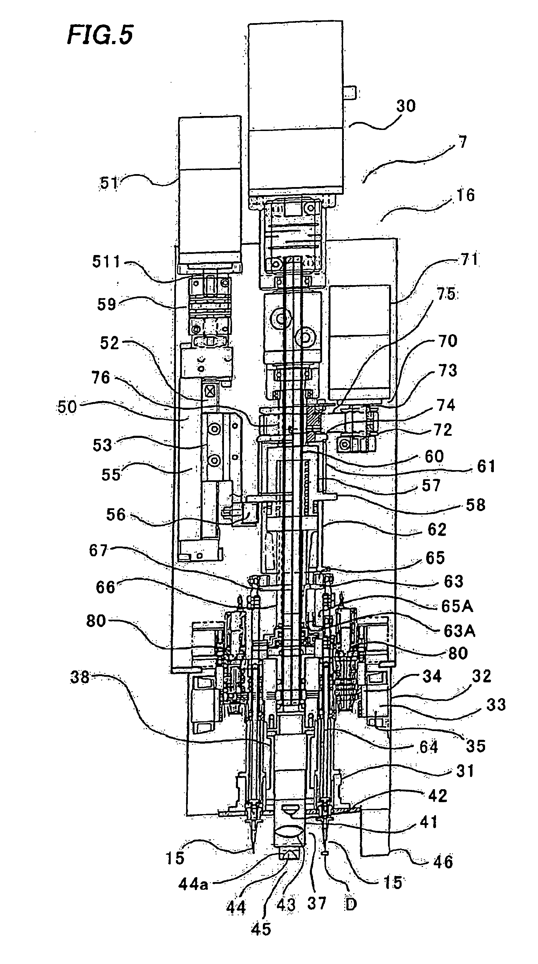

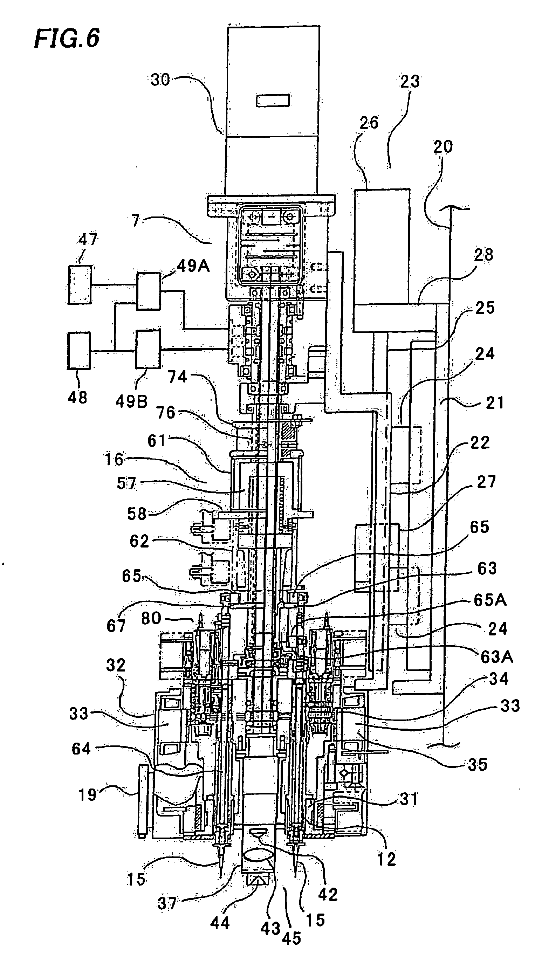

A vertical movement device for the mounting head 16 will be described in detail with reference to Figs. 5 and 6. A numeral 20 designates a board of the mounting head body 7 moving along the guide 13, and a numeral 21 designates a beam side base fixed to this board 20. A numeral 22 designates a mounting head side base fixed to upper and lower portions of the mounting head 16. A head vertical movement device 23 is provided between this mounting head side base 22 and the beam side base 21.

The head vertical movement device 23 has a guide 24 guiding the mounting head 16 when the mounting head 16 vertically moves, a ball screw 25 attached to the beam side base 21, a head vertical movement motor 26 vertically moving the mounting head 16 by rotating the ball screw 25, a vertical movement nut 27 engaged with the ball screw 25, and a support body 28 attached to the head vertical movement motor 26 and rotatably supporting an upper portion of the ball screw 25. The vertical movement nut 27 is fixed to the head side base 22. Thus, rotation of the ball screw 25 by rotation of the head vertical movement motor 26 makes the vertical movement nut 27 vertically move, resulting in vertical movement of the mounting head 16.

A numeral 30 designates a slip ring provided for communication between the mounting apparatus and the mounting head 16 and for power supply to a rotation motor of a nozzle support portion which will be described below. A numeral 31 designates a nozzle support body provided in a lower portion of the mounting head 16 and supporting each of twelve suction nozzles 15 provided on a circumference thereof at predetermined intervals, which are vertically movable. A numeral 32 designates an outer cylinder in a lower portion of the mounting head 16, and a numeral 33 designates a nozzle rotation motor as a pulse motor for θ rotation of the suction nozzle 15 provided between the outer cylinder 32 and the nozzle support body 31. A rotor 34 of this nozzle rotation motor 33 is provided on an outer circumference surface of the nozzle support body 31, being rotatable in a θ direction inside a stator 35 provided in the outer cylinder 32 together with the nozzle support body 31.

A numeral 37 designates a line sensor unit for detecting presence or absence, an attached posture (attachment state), and a lower end of the electronic component D, protruding downward from a center of the head support body 31. The line sensor unit 37 has a light emitting unit 45 and a light receiving unit 46. The light emitting unit 45 is provided in a lower end of the support body 38 in the almost center position of the mounting head 16, and has a light emitting element 42 such as an LED in an upper part of a cylindrical light emitting unit attachment body 41, a lens 43 below the light emitting element 42, and a reflector 44 having a conic reflective surface 44a provided below the lens 43. A light receiving unit 46 is fixed to a bottom surface of the outer cylinder 32, and has CCD elements as a plurality of light receiving elements for receiving light emitted from the light emitting element 42 through the reflector 44.

This enables differentiating a case where the electronic component is picked up with a normal position as shown in Fig. 5 from a case where the component is picked up with its wrong surface being attached to the suction nozzle, i.e., standing or slanting, since height of a lower end surface of the electronic component D can be detected by recognizing a border between the position receiving no light and the position receiving light in each of the CCD elements in each time when the nozzle support body 31 rotates after a pickup operation of an electronic component D is completed by the suction nozzle 15 provided on the mounting head 16 and selected for picking the component. In detail, after the suction nozzle 15 lowers, picks up the electronic component D from the component feeding unit 3 by suction, and rises up, the nozzle rotation motor 33 is driven to rotate the nozzle support body 31 and rotate the suction nozzle 15 holding the electronic component D by suction. When the electronic component D held by the suction nozzle 15 comes between the reflector 44 and the light receiving unit 46 during rotation of the suction nozzle 15, presence or absence and an attached posture of the component can be detected by detecting height of the lower end surface of the electronic component D at plural positions. Although the detection is performed during rotation and movement of the nozzle support body 31 in this embodiment, alternatively the detection can be performed with the rotation being stopped when the electronic component D comes between the reflector 44 and the light receiving unit 46.

In a case where the suction nozzle 15 does not hold the electronic component D by suction, light emitted from the light emitting element 42, which should be shielded (by the held electronic component), is received by the light receiving unit 46. Thus, a detection result is "absence" of the electronic component D, so that by an operation of a solenoid valve 82 as a vacuum valve switch effector, which will be described below, provided on a side of each of the nozzle axes 64, a vacuum path is disconnected from a vacuum source 47 to stop the vacuum suction, thereby preventing leakage. In a case where the electronic component is detected as being attached to the suction nozzle 15 at its wrong surface, i.e., with standing or slanting, the mounting head 16 and the suction nozzle 15 move to a position above a collection box 79, drops the electronic component D therein.

A numeral 50 designates a nozzle vertical movement device provided on the mounting head 16. Description will be made on this nozzle vertical movement device, hereafter. A numeral 51 designates a motor for vertically moving a nozzle (referred to as a nozzle vertical movement motor, hereafter) attached to the head side base 22, and a numeral 52 designates a ball screw connected with a rotation axis 511 of the nozzle vertical movement motor 51 through a connection member 59 and rotating driven by the nozzle vertical movement motor 51, a numeral 53 designates a vertical movement body engaged with the ball screw 52 and vertically moving by rotation of the ball screw 52, a numeral 55 designates a guide attached to the head side base 22 and guiding the vertical movement body 53 for vertical moving, and a numeral 56 designates a roller rotatably attached to a lower end of the vertical movement body 53.
Furthermore, a numeral 57 designates a first cylinder where a center axis 60 of the mounting head 16 penetrates a center thereof, a roundel 58 formed on the first cylinder 57 is positioned on the roller 56, the fist cylinder 57 being supported by the roller 56. The first cylinder 57 is formed of a ball spline, for example, and pulled downward by a spring 61 of which a lower end is attached to an upper surface of the roundel 58. This first cylinder 57 rotates by θ with θ rotation of a pulley which will be described below, and vertically moves together with a vertical movement of the vertical movement body 53 and a vertical movement of the roller 56. A numeral 62 designates a nozzle support member fixed to a lower portion of the first cylinder 57 and rotates by θ with the first cylinder 57. A vertical movement support piece 63 is formed on a lower end of this nozzle support member 62, horizontally lying in a circumference direction. This vertical movement support piece 63 vertically moves together with vertical movement of the first cylinder 57. The lowering of the vertical movement support piece 63 makes a predetermined suction nozzle 15 among a plurality of nozzles lower.

In detail, a roller 65 is rotatably attached to an upper end of each of the nozzle axes 64 extending upward from each of the suction nozzles 15. The roller 65 on the upper end of the nozzle axis 64 of the suction nozzle 15 selected by a nozzle selection device which will be described below lowers by lowering of the nozzle support member 62 and the vertical movement support piece 63 by lowering of the first cylinder 57, the roller 65 being positioned on an upper surface of the vertical movement support piece 63. In detail, when the vertical movement support piece 63 and the roller 65 lower to a position shown by the vertical movement support piece 63A and the roller 65A, for example, the predetermined nozzle 15 lower with this lowering. Furthermore, by controlling a rotation amount of the nozzle vertical movement motor 51 and adjusting a height where the vertical movement body 53 should stop during lowering, the suction nozzle 15 can lower by a predetermined stroke.

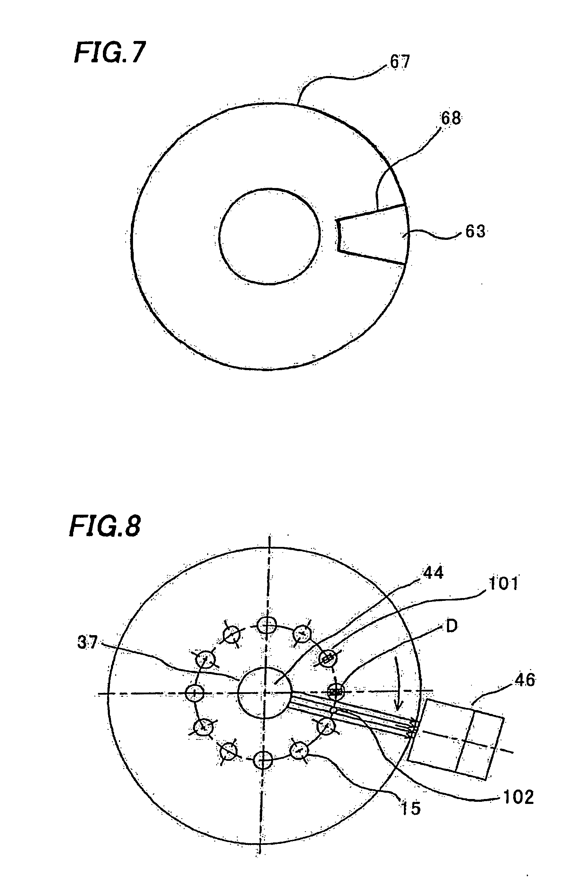

A numeral 66 designates a third cylinder provided under the nozzle support member 62, which is rotatable by θ. On an upper portion of this third cylinder 66, a fixing support piece 67, which has a disk like shape, is formed at the same height as that of the vertical movement support piece 63 of the nozzle support member 62 before lowered. The fixing support piece 67 is formed with a notch 68 for the vertical movement support piece 63 as shown in Fig. 7. Each of the rollers 65 on the upper ends of the nozzle axes 64 of the nozzles 15 except the above-described nozzle 15 to be lowered is supported by the fixing support piece 67. That is, the fixing support piece 67 has the notch 68 formed in a position of one of some-degree divided pieces thereof calculated by dividing the piece 67 equally into the same number of pieces as the number of the nozzles 15 in a circumference direction, for example, in a position of a 30-degree piece which is one of 12 divided pieces in this embodiment. The vertical movement support piece 63 of the nozzle support member 62 is positioned in this notch 68.

A numeral 70 is a nozzle selection device provided on the mounting head 16, a numeral 71 designates a nozzle selection motor for selecting a nozzle to be lowered, a numeral 72 designates a first pulley fixed to a rotation axis 73 of the nozzle selection motor 71, a numeral 74 designates a second pulley rotatably supported by the center axis 60, a numeral 75 designates a belt stretched between the first pulley 72 and the second pulley 74, and a numeral 76 designates a cylindrical rotator provided on an outside of the center axis 60, extending downward from a center of the second pulley 74. The spring 61 is provided between the second pulley 74 and the roundel 58 of the first cylinder 57.

The first cylinder 57 is formed on an outside of outer circumference of the lower portion of the rotator 76. By the function of the first cylinder 57 as a ball spline, the first cylinder 57 rotates with rotation of the second pulley 74 and rotation of the rotator 76. Furthermore, the first cylinder 57 vertically moves with vertical movement of the vertical movement body 53 along the rotator 76.

In detail, when the nozzle for picking and mounting the electronic component D is to be selected, the nozzle selection motor 71 rotates, so that the first cylinder 57 rotates through the first pulley 72, the belt 75, the second pulley 74, and the rotator 76. Then, the nozzle support member 62 connected with the first cylinder 57 rotates together with the third cylinder 66, so that the vertical movement support piece 63 of the nozzle support member 62 comes to the nozzle axis 64 extending from the selected nozzle 15. With this state, the nozzle vertical movement motor 51 rotates, and the vertical movement body 53 lowers corresponding to the thickness of the electronic component to be picked up and mounted, so that the first cylinder 57 and the nozzle support member 62 lower and thus the vertical movement support piece 63 lowers, thereby lowering only the selected nozzle 15 by a predetermined stroke corresponding to the thickness of the electronic component.

A numeral 80 is an air switch valve switchable between air suction and air blow in each of the nozzles 15, being provided for each of the nozzles 15 at predetermined intervals in the circumference direction on the outer side of the nozzles. This air switch valve 80 has a case 81 provided in an upper portion thereof, and a solenoid valve 82 of which the upper portion is positioned inside this case 81 and electrical conduction is controlled by a signal from the CPU 90. The solenoid valve 82 has a circular electromagnet 83 provided on an inner surface of the case 81, a path switch body 85 provided with a cylindrical permanent magnet 84 corresponding to the electromagnet 83 in its upper portion and vertically moving inside the case 81 according to electrical conduction and electrical non-conduction through the electromagnet 83, and so on. An air blow path 86, a nozzle connection path 87, and a vacuum leading path 88 are formed between the path switch body 85 and a cylinder portion 81A in the lower portion of the case 81 in due order from upper to lower sides. Furthermore, the nozzle axis 64 has a nozzle axis path 100 connected with an inner path of the nozzle 15 and the nozzle connection path 87. By the vertical movement of the path switch body 85, the connection of the nozzle path 100 switches to between the vacuum leading path 88 and the air blow path 86 through the nozzle connection path 87.

In detail, when the path switch body 85 rises by electrical conduction of the solenoid valve 82 through the electromagnet 83, the vacuum leading path 88 and the nozzle connection path 87 are connected to each other, and the nozzle connection path 87 and the air blow path 86 are disconnected from each other. Therefore, the inner path of the suction nozzle 15 is connected to a vacuum source 47 through the nozzle axis path 100, the nozzle connection path 87, and the vacuum leading path 88, so that the suction nozzle 15 keeps vacuum suction of the electronic component. On the other hand, when the connection switch body 85 lowers by electrical non-conduction through the electromagnet 83, the vacuum leading path 88 connected with the vacuum source 47 and the nozzle connection path 87 are disconnected from each other, and the nozzle connection path 87 and the air blow path 86 are connected to each other. Therefore, the vacuum suction of the electronic component D by the suction nozzle 15 stops, and air from an air supply source 48 is blown in the inner path of the suction nozzle 15 through the air blow path 86, the nozzle connection path 87, and the nozzle axis path 100.

In this manner, the connection of the suction nozzle 15 with the vacuum source 47 and the air supply source 48 can be switched by electrical conduction and electrical non-conduction of the air switch valve 80 (the electromagnet 83 of the solenoid valve 82) provided for each of the suction nozzles 15. Thus, the air switch valve 80 for the selected suction nozzle 15 can be switched independently.

A numeral 49A designates a switch valve connected with the air switch valve 80 in one end, which switches its connection with the vacuum source 47 and the air supply source 48 so as to make the suction nozzle 15 suck and blow respectively. A numeral 49B designates an open-close valve connected with the air switch valve 80 in one end and with the air supply source 48 in another end. This is a valve used for mounting an electronic component by the suction nozzle 15 by establishing a state of blowing air from the air supply source 48 by its opening before the air switch valve 80 switches from air suction to air blow and then breaking vacuum when the air switch valve 80 switches to the air blow as the suction nozzle 15 picking the electronic component starts lowering.

A numeral 89 designates a component recognition camera. The component recognition camera 89 is provided on each of attachment boards 99 of the base 2 so that there are four cameras 89 in total each corresponding to each of the mounting heads 16. The camera 89 sequentially takes images of all the electronic components D picked up by the suction nozzles 15 to detect an amount of shifting from a proper position of the electronic component D on the suction nozzle 15 in X and Y directions and at rotating angles. The camera 89 can also take images of the plurality of the electronic components D at the same time. Furthermore, the component recognition camera 89 can recognize whether or not the electronic component D is held by suction by the suction nozzle 15 by taking an image.

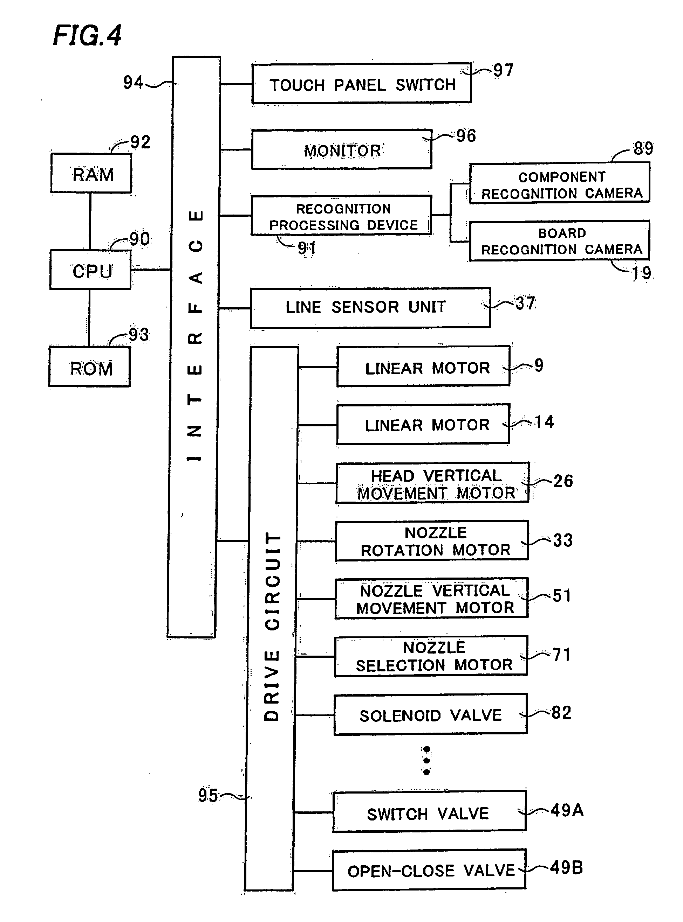

Next, description will be made with reference to a block diagram showing a control of the electronic component mounting apparatus 1 in Fig. 4. A numeral 90 designates the CPU (mounting control portion) as a control portion for controlling the mounting apparatus 1. The CPU 90 is connected with a RAM (random access memory) 92 and a ROM (read only memory) 93 through buses. The CPU 90 controls all operation for component mounting of the electronic component mounting apparatus 1 according to programs stored in the ROM 93 based on data stored in the RAM 92. That is, the CPU 90 controls driving of the linear motors 9 and 14, the head vertical movement motor 26, the nozzle rotation motor 33, the nozzle vertical movement motor 51, the nozzle selection motor 71, the solenoid valve 82, the open-close valve 49B and the switch valve 49A provided in each of the mounting heads 16, and so on through the interface 94 and the drive circuit 95.

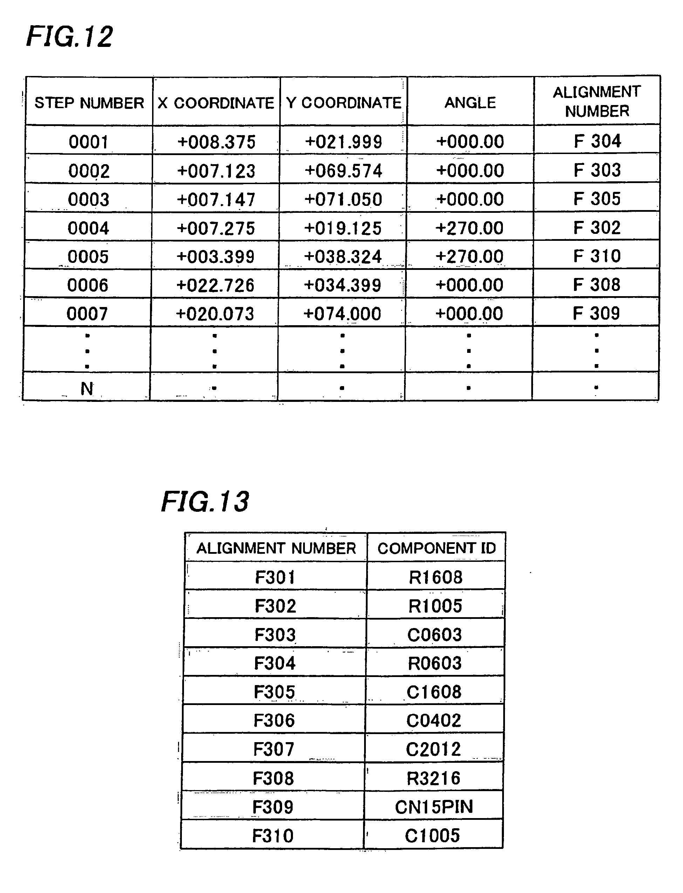

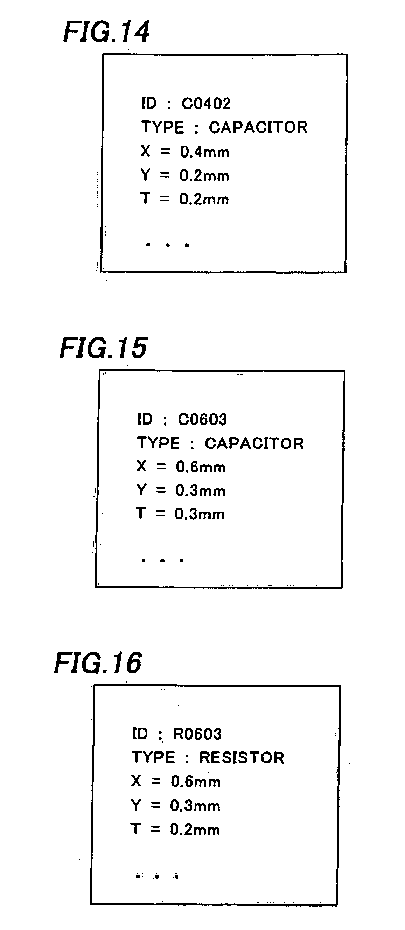

The RAM 92 is stored with mounting data on component mounting as shown in Fig. 12 which include the X and Y coordinates and an angle on the printed board, alignment numbers of the component feeding units 3, and so on in order of component mounting (in order of step number). Furthermore, the RAM 92 is stored with component disposition data as shown in Fig. 13 which include a type of the electronic component (component ID), and so on corresponding to alignment numbers of the component feeding units 3. The RAM 92 is further stored with component library data as shown in Figs. 14 to 16 which include the type, sizes in the X and Y directions and in the thickness direction (height), and so on of each of the electronic components (component ID). For example, as shown in Fig. 14, the component ID "C0402" is a capacitor in the type, and 0.4mm, 0.2mm, and 0.2mm in the sizes in the X direction, the Y direction, and the thickness direction respectively.

A numeral 91 designates a component recognition processing device connected with the CPU 90 through the interface 94. In the component recognition processing device 91, images taken and stored by the component recognition camera 89 and the board recognition camera 19 undergo recognition processing.

The images taken by the component recognition camera 89 and the board recognition camera 19 are displayed on a monitor 96 as a display device. The monitor 96 is provided with various touch panel switches 97 and an operator operates the touch panel switches 97 for various settings including settings for informing.

The touch panel switches 97 include a glass substrate which is coated with a transparent conductive film on its whole surface and printed with electrodes on its four edges. When an operator touches one of the touch panel switches 97 in a state where minimal electric currents flow on the surface of the touch panel switches 97, current flows change at the four electrodes and coordinates of a touched position are calculated by a circuit board connected with the electrodes. If the calculated coordinates correspond to one of coordinates originally stored in the RAM 92, which will be described below, as a switch for executing a certain operation, the operation is executed.

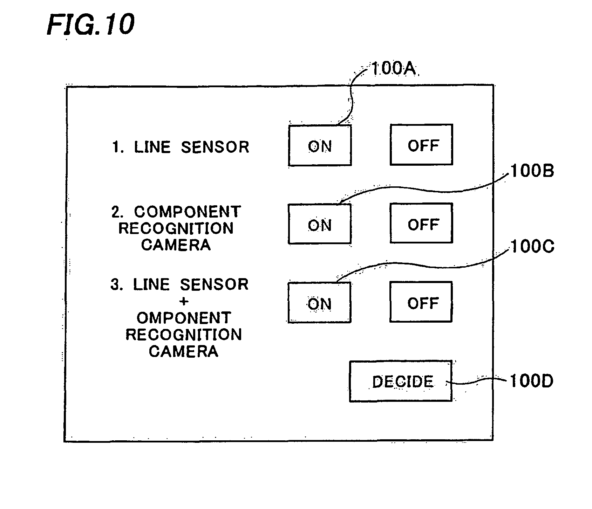

Under the structure described above, a screen as shown in Fig. 10 is displayed on the monitor 96, and then selection is made from the line sensor unit 37 only, the component recognition camera 89 only, and both the line sensor unit 37 and the component recognition camera 89, for use for detecting whether or not the suction nozzle 15 still holds the electronic component after the mounting operation of the electronic component on the printed board P. Suppose that the line sensor unit 37 only is selected for the detection, first. An operator pushes a switch portion 100A and then a decision switch 100D to set the detection by the line sensor unit 37 only. The set content is stored in the RAM 92, and the CPU 90 controls a detecting operation according to a program corresponding to the set content stored in the ROM 93.

This setting can be performed on each group of the electronic components having a same type or in mounting order in the mounting data of electronic components.

Hereafter, the picking and mounting operation of the electronic component D by the electronic component mounting apparatus 1 will be described. First, the printed board P is conveyed from upstream to the positioning portion 5 through the feed conveyer 4, and the positioning device starts a positioning operation.

Next, the CPU 90 forms pickup sequence data from the mounting data stored in the RAM 92. That is, the CPU 90 reads out data from the mounting data, decides a picking-up procedure of the suction nozzles 15, detects the last component feeding unit 3 which feeds the last electronic component D in a sequential picking-up process (12 components can be picked up for one mounting head 16 at maximum) and stores coordinates of a last pickup position of the component feeding unit 3 in the RAM 92, detects coordinates of a first mounting position of the component D after completing the sequential picking-up process (a position stored in mounting data before alignment) and stores the coordinates in the RAM 92.

Then, picking-up of the electronic components D is performed. In detail, the suction nozzles 15 corresponding to types of the electronic components pick up the electronic components to be mounted from the predetermined component feeding units 3 according to the mounting data and so on stored in the RAM 92 where the position of the X and Y coordinates on the printed board to be mounted with the component, a position at a rotation angle around a vertical axis, an alignment number and so on are specified.

For this pickup operation, by the linear motors 9 and 14 controlled by the CPU 90, the suction nozzle 15 of the mounting head 16 in the mounting head body 7 moves to a position above the first electronic component in the component feeding unit 3 which has the electronic components to be mounted. Each of the head bodies 7 moves in the Y direction by moving of the beam 8 along the pair of the guides 10 driven by the linear motor 9 and in the X direction along the guides 13 driven by the linear motor 14, both the linear motors 9 and 14 being driven by the drive circuit 95.

At this time, the predetermined component feeding unit 3 is already driven and the electronic component is ready to be picked up at a feeding position of the unit 3. Therefore, based on a signal outputted by the CPU 90 through the interface 94 and the drive circuit 95 during the movement of each of the mounting head bodies 7, the head vertical movement motor 26 rotates and the mounting head 16 lowers to a predetermined height along the guide 24, that is, the height where the suction nozzle 15 does not contact the other structure components such as the feeding units 3 at all. Then, when the suction nozzle (referred to as a first suction nozzle, hereafter) 15 for picking the electronic component first is being shifted from a pickup position, that is, a pickup position 101 (set this position as 0 degree) shown in Fig. 8 which is a schematic bottom view of the mounting head 16, the CPU 90 outputs a signal to move the suction nozzle 15 to the pickup position 101 shown in Fig. 8, and the nozzle rotation motor 33 rotates based on this signal. By the drive of the nozzle rotation motor 33, the nozzle support body 31 of the mounting head 16 rotates by θ around the center axis 60.

Then, the suction nozzle 15 is ready to start lowering at the time when the roller 65 is positioned on the vertical movement support piece 63.

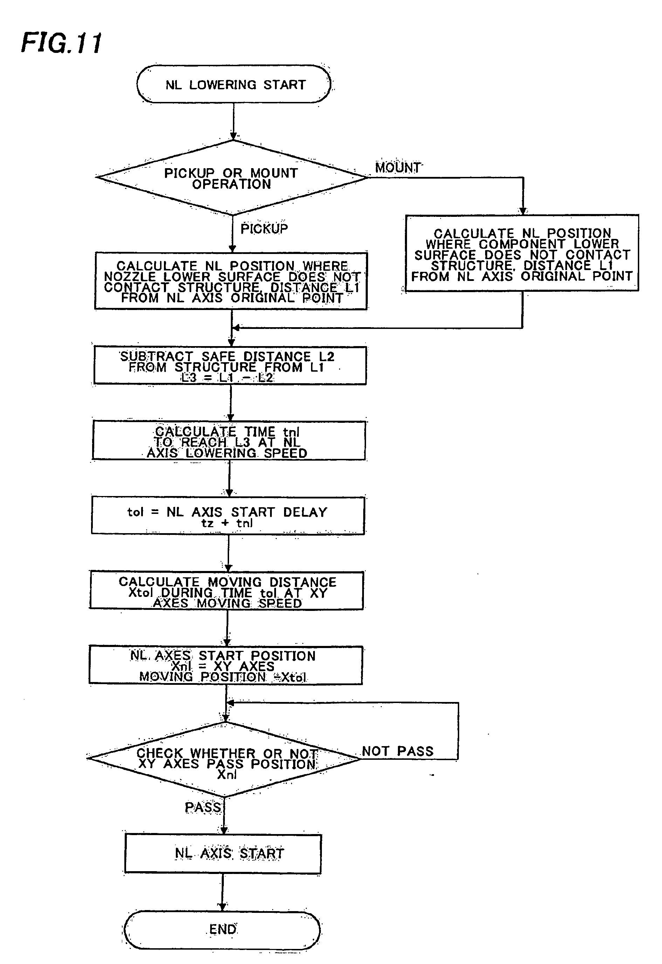

Hereafter, a relation between the movement in the Y and X directions of the beam 8 and the mounting head body 7 as the X and Y axes (the movement of the X and Y axes in the X and Y directions) and timing to start the lowering of the suction nozzle 15 will be explained referring to a flow chart of Fig. 11.

When the suction nozzle 15 is to lower in the described pickup operation of the electronic component by the suction nozzle 15, the CPU 90 calculates a height (position) Hlof the lower surface of the suction nozzle (NL axis) 15 where the lower surface of the suction nozzle 15 does not contact the other structure components, for example, the upper portion of the component feeding unit 3 such as a suppressor as the upper portion of a tape feeder supplying a component from a component storage tape, and calculates a distance L1 from the original point of the suction nozzle 15 before it starts lowering to the height position H1.

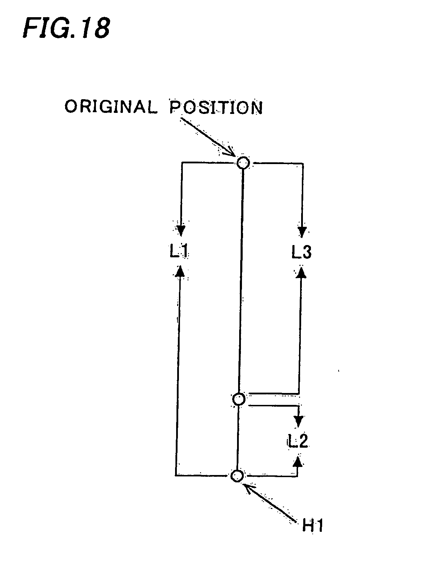

Then, the CPU 90 subtracts a safe distance L2 from the structure components from the distance L1 to obtain a distance L3, the safe distance L2 being set and stored in the RAM 92 in advance. This relationship is shown in Fig. 18.

Then, the CPU 90 calculates time tnl from the time when the suction nozzle 15 starts lowering until the time when the suction nozzle 15 reaches the distance L3 at its lowering speed (set for each of the types of the electronic components and stored as the component library data in the RAM 92 in advance). The CPU 90 further calculates start delay time of the nozzle vertical movement motor 51 for vertically moving the suction nozzle 15, that is, time (NL axis start delay) tZ from the time when the CPU 90 outputs an operation signal for the nozzle vertical movement motor 51 until the time when the nozzle vertical movement motor 51 actually starts operating, which is stored in the RAM 92. Then, the CPU 90 adds the NL axis start delay time tZ and the time tnl to obtain overlap time tol.

Next, the CPU 90 calculates a moving distance Xtol of the suction nozzle 15, which is a moving distance in the Y and X directions of the beam 8 and the mounting head body 7 during the overlap time tol at a X and Y axes moving speed (set for each of the types of the electronic components and stored as the component library data in the RAM 92 in advance) which is the moving speed in the Y and X directions of the beam 8 and the mounting head body 7 as the X and Y axes and also the moving speed in the horizontal direction of the suction nozzle 15 during the overlap time tol by the operation of the linear motors 9 and 14.

Next, the CPU 90 determines the position returned from the pickup position by the moving distance Xtol calculated as above in the rbute of the suction nozzle 15 to the pickup position (X and Y axes movement position) as its destination, that is, the position of the suction nozzle 15 moved by a distance obtained by subtracting the moving distance Xtol from its moving distance to the pickup position, as the timing to start the lowering of the suction nozzle 15, that is, the position of the suction nozzle 15 (NL axis start position) Xnl where the CPU 90 is to output an operation signal to the nozzle vertical movement motor 51 for lowering the motor 51.

The CPU 90 observes the position of the X and Y axes during the movement of the suction nozzle 15 along with the movement of the X and Y axes which is the movement of the beam 8 and the mounting head body 7 in the Y and X directions. When the CPU 90 recognizes that the X and Y axes pass the position Xnl, that is, that the first suction nozzle 15 for lowering for picking a component first passes the position Xnl, the CPU 90 outputs a signal to the nozzle vertical movement motor 51 through the interface 94 and the drive circuit 95. Based on this signal, the nozzle vertical movement motor 51 rotates in the direction for lowering the first suction nozzle 15, the vertical movement body 53 and the vertical movement support piece 63 lower by the rotation of the ball screw 52, and the first suction nozzle 15 lowers toward the predetermined height, that is, the previously set height suitable for picking an electronic component up from the feeding unit 3 while the nozzle 15 moves in the X and Y directions (in the horizontal direction). That is, the first suction nozzle 15 reaches the electronic component pickup position of the component feeding unit 3, and reaches the height for picking the electronic component simultaneously.

In this manner, when the first suction nozzle 15 is to lower in the pickup operation of the electronic component, the CPU 90 determines the lowering start position of the suction nozzle 15 during its movement, based on the start delay time of the nozzle vertical movement motor 51 for vertically moving the suction nozzle 15, that is, the time (NL axis start delay) tZ from the time when the CPU 90 outputs an operation signal for the nozzle vertical movement motor 51 until the time when the nozzle vertical movement motor 51 actually starts operating, which is stored in the RAM 92, and the time tnl from the time when the suction nozzle 15 starts lowering until the time when the suction nozzle 15 reaches the distance L3 at its lowering speed (set for each of the types of the electronic components and stored as the component library data in the RAM 92 in advance), and then the CPU 90 outputs an operation signal for the nozzle vertical movement motor 51 as early as possible. This realizes the earlier timing to start the lowering of the suction nozzle 15 during the movement of the mounting head 16, that is, during the movement of the suction nozzle 15, and further the earlier timing to start the picking of the electronic component by the suction nozzle 15.

When the start delay time tZ of the nozzle vertical movement motor 51 is largely shorter than the time tnl from the time when the suction nozzle 15 starts lowering until the time when the suction nozzle 15 reaches the distance L3 at its lowering speed, it is possible to set the time tnl which changes depending on the lowering speed of the suction nozzle 15 as the overlap time tol without adding the start delay time tZ of the nozzle vertical movement motor 51 to the time tnl. By changing the overlap time tol depending on the lowering speed of the suction nozzle 15 which changes depending on the component types, the earlier timing to start the lowering of the suction nozzle 15 can be realized depending on the component types, especially when the lowering speed of the suction nozzle 15 is low.

Then, when the suction nozzle 15 is to mount its electronic component on the printed board, the CPU 90 calculates a position H2 of the height of the suction nozzle 15 where the lower surface of the held electronic component does not contact the components already mounted on the printed board, and calculates the distance L1 from the original point of the suction nozzle 15 before it starts lowering to the height position H2.

Then, the CPU 90 subtracts the safe distance L2 from the structure components, which is set and stored in the RAM 92 in advance, from the distance L1 to obtain the distance L3.

Then, in the same manner as in the above-described pickup operation of the electronic component, the CPU 90 determines the lowering start position of the suction nozzle 15 during its movement based on the time (NL axis start delay) tZ from the time when the CPU 90 outputs an operation signal for the nozzle vertical movement motor 51 until the time when the nozzle vertical movement motor 51 actually starts operating, and the time tnl from the time when the suction nozzle 15 starts lowering until the time when the suction nozzle 15 reaches the distance L3 at its lowering speed, and the CPU 90 outputs an operation signal for the nozzle vertical movement motor 51 as early as possible. This realizes the earlier timing to start the lowering of the suction nozzle 15 during the movement of the mounting head 16, that is, the movement of the suction nozzle 15 in the X and Y directions, and furthermore the earlier timing to start the mounting of the electronic component by the suction nozzle 15.

As a result of this, the mounting time of each of the electronic components can be minimized.

It is possible that the first suction nozzle 15 starts lowering during its rotation toward the pickup position 101, so that the first suction nozzle 15 can perform its rotation to the pickup position 101 and its lowering at the same time. This can reduce the time required for the pickup operation of the electronic component D, resulting in reduction of the time required for mounting the electronic component on the printed board. The rotation of the suction nozzle 15 starts while the mounting head 16 is moving in X and Y directions like its lowering.

Furthermore, it is possible that the first suction nozzle 15 starts its lowering much earlier than above during the rotation of the nozzle support body 31 by θ described above. The control of this will be described hereafter. The CPU 90 outputs a signal for moving the suction nozzle 15 to the pickup position 101 shown in Fig. 8, and the nozzle selection motor 71 outputs a signal so that the vertical movement support piece 63 moves to a position corresponding to the first suction nozzle 15 based on the signal from the CPU 90. Therefore, by the drive of the nozzle rotation motor 33, the nozzle support body 31 of the mounting head 16 rotates around the center axis 60 by θ, and simultaneously the rotation of the nozzle selection motor 71 makes the nozzle support member 62 rotate through the first pulley 72, the belt 75, the second pulley 74, and the first cylinder 57. By the rotation of the nozzle support member 62, the vertical movement support piece 63 rotates to reach the position corresponding to the first suction nozzle 15 to be vertically moved.

Since the first suction nozzle 15 does not reach the pickup position 101 yet at this time, the nozzle support body 31 continues the θ rotation around the center axis 60. The CPU 90 outputs a signal to rotate the vertical movement support piece 63 so as to keep the position corresponding to the first suction nozzle 15, so that the vertical movement support piece 63 rotates with the θ rotation of the nozzle support body 31 by the rotation of the nozzle support member 62.

In addition, at the time when the vertical movement support piece 63 reaches the position corresponding to the first suction nozzle 15, the first suction nozzle 15 is ready to lower and the CPU 90 outputs a signal to the nozzle vertical movement motor 51 through the interface 94 and the drive circuit 95. Based on this signal, the nozzle vertical movement motor 51 rotates in a direction for lowering the first suction nozzle 15, the ball screw 52 rotates to lower the vertical movement body 53 and then the vertical movement support piece 63, so that the first suction nozzle 15 lowers to the predetermined height suitable for picking the electronic component from the feeding unit 3. Accordingly, by the θ rotation of the nozzle support body 31 and the lowering of the vertical movement support piece 63, the first suction nozzle 15 rotates and lowers to reach the pickup position 101 and the height suitable for picking the electronic component.

In this manner, the first suction nozzle 15 can perform its rotation to the pickup position 101 and its lowering at the same time, since the first suction nozzle 15 starts lowering from the time when the first suction nozzle 15 is still shifted from the pickup position 101 by 15 degrees or more during the rotation of the first suction nozzle 15 to the pickup position 101. Therefore, the lowering of the first suction nozzle 15 can start much earlier, so that the time required for the pickup operation of the electronic component D can be more reduced, resulting in more reduction of the time required for mounting the electronic component on the printed board.

When the first suction nozzle 15 reaches the pickup position 101 and the height suitable for picking the electronic component, as described above, the solenoid valve 82 corresponding to the first suction nozzle 15 rises by electrical conduction based on a signal from the CPU 90 and a path switch body 85 rises. Then, the vacuum leading path 88 and the nozzle connection path 87 are connected to each other, and the nozzle connection path 87 and the air blow path 86 are disconnected. The inner path of the suction nozzle 15 is connected to the vacuum source 47 through the nozzle axis path 100, the nozzle connection path 87, the vacuum leading path 88, and the switch valve 49A switched to the suction side, and the suction nozzle 15 keeps the vacuum suction of the electronic component.

When the pickup operation of the electronic component by the first suction nozzle 15 is completed as described above, the CPU 90 outputs a signal to the nozzle vertical movement motor 51, and based on this signal the nozzle vertical movement motor 51 rotates in the direction for moving the first suction nozzle 15 upward and the vertical movement body 53 rises to a predetermined height, that is, the height before the body 53 lowers by the rotation of the ball screw 52.

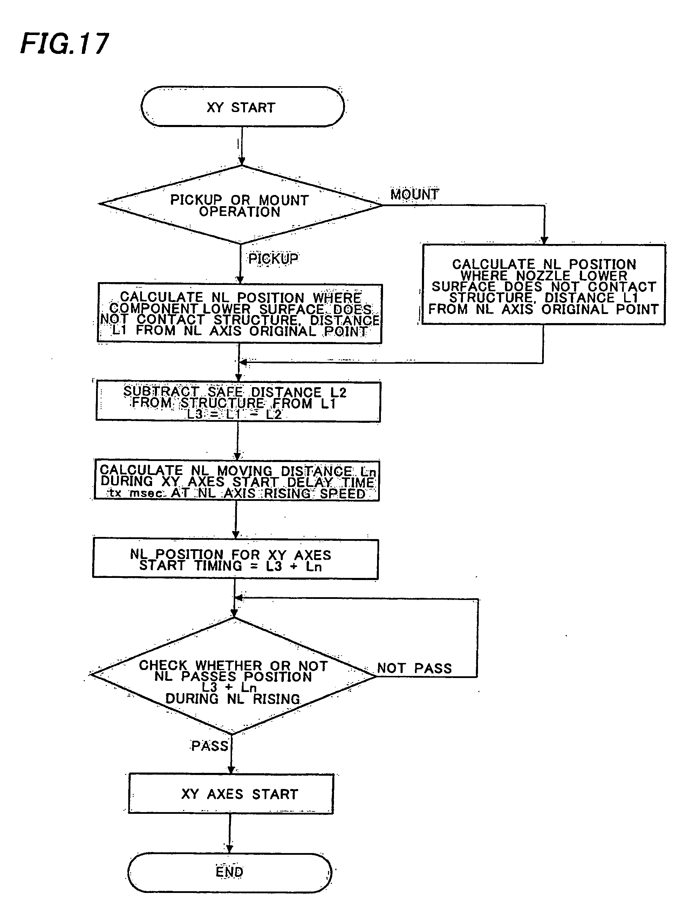

Hereafter, description will be given on a relation between the rising of the suction nozzle 15 and timing to start the movement of the beams 8 and the mounting head body 7 in the Y and X directions by the linear motors 9 and 14 respectively (the start timing of the X and Y axes) in the pickup operation of the electronic component by the first suction nozzle 15, based on a flow chart of Fig. 17.

When the suction nozzle 15 is to rise in the pickup operation of the electronic component by the suction nozzle 15, the CPU 90 calculates the height (position) H1 of the lower surface of the suction nozzle (NL axis) 15, where the lower surface of the electronic component held by the suction nozzle 15 by suction (the position obtained by adding the thickness of the component as T data in the component library data shown in Figs. 14 and 16 to a value of the position of the lower surface of the suction nozzle) does not contact the other structure components, for example, the suppressor which is the upper portion of the tape feeder as the component feeding unit 3 supplying components from the component storage tape, and calculates the distance L1 from the original point of the suction nozzle 15 before it starts lowering to the height position H1.

Then, the CPU 90 subtracts the safe distance L2 from the structure components from the distance L1 to obtain the distance L3, the distance L2 being set and stored in the RAM 92 in advance.

Then, the CPU 90 calculates a distance Ln of the rising of the first suction nozzle (NL axis) at its rising speed (set for each of the types of the electronic components and stored as the component library data in the RAM 92 in advance) during the start delay time of linear motors 9 and 14 for moving the suction nozzle 15, that is, the mounting head 7 in the X and Y directions, that is, during the time (X and Y axes start delay) tX from the time when the CPU 90 outputs an operation signal for the linear motors 9 and 14 until the time when the linear motors 9 and 14 actually start operating, that is stored in the RAM 92.

Then, the CPU 90 determines the position obtained by adding the distance Ln to the distance L3 which is from the original point of the first suction nozzle 15 toward the lower side, as the start timing of the linear motors 9 and 14 (X and Y axes start timing), that is, the time point of outputting an operation signal from the CPU 90 to the linear motors 9 and 14 for those movement.

While the first suction nozzle 15 is rising, the CPU 90 observes the position of the lower surface of the electronic component which the first suction nozzle 15 holds based on a rising distance of the first suction nozzle 15. When the CPU 90 recognizes that the lower surface of the electronic component which the first suction nozzle 15 holds passes the position (L3+Ln), the CPU 90 outputs a signal to the linear motors 9 and 14 through the interface 94 and the drive circuit 95. Based on this signal the linear motors 9 and 14 start operating (X and Y axes start), the beam 8 and the mounting head body 7 move in the Y direction and X direction respectively, and thus the first suction nozzle 15 moves in the X and Y directions.

In this manner, when the first suction nozzle 15 is to rise in the electronic component pickup operation, the CPU 90 determines the position of the suction nozzle 15 for starting the linear motors 9 and 14 during the rising of the suction nozzle 15, taking account of the start delay time of the linear motors 9 and 14 for moving the suction nozzle 15 in the X and Y directions, that is, the time (X and Y axes start delay) tX from the time when the CPU 90 outputs an operation signal to the linear motors 9 and 14 until the time when the linear motors 9 and 14 actually start operating, that is stored in the RAM 92. This realizes the earlier start timing of the linear motors 9 and 14, that is, the earlier timing to start the moving of the beam 8 and the mounting head body 7 as the X and Y axes during the rising of the suction nozzle 15, and further the earlier timing to start the next picking of the electronic component or the next mounting of the electronic component by the next suction nozzle 15.

As a result of this, the mounting time of each of the electronic components can be minimized.

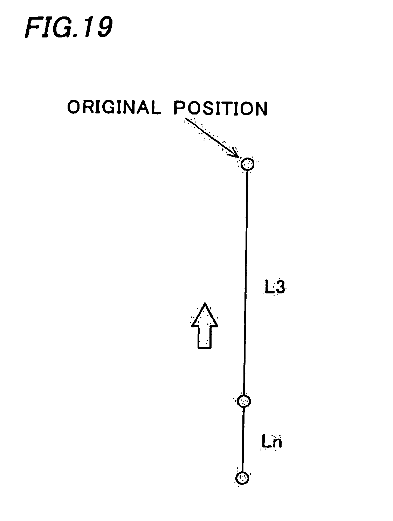

Fig. 19 schematically shows this rising process of the suction nozzle 15. When the suction nozzle 15 rises to the position shown in the bottom of the drawing, the horizontal movement is triggered. However, because of the start delay time, while the suction nozzle 15 is climbing the distance Ln shown in Fig. 19, the suction nozzle 15 does not move horizontally. When the suction nozzle 15 rises to the position shown in the middle of the drawing, i.e., the end of the start delay time, the suction nozzle 15 actually starts to move horizontally. Since the middle position is at the level to assure a horizontal movement of the suction nozzle 15 without interference from other components of the mounting apparatus, the suction nozzle 15 moves safely in the horizontal direction. Finally, the suction nozzle reaches the "original position," which is actually a vertical level from which the suction nozzle 15 starts descending and to which the suction nozzle 15 comes back as a default vertical position.

While the mounting head body 7 moves in the X and Y directions by the operation of the linear motors 9 and 14, the first suction nozzle 15 is shifted, and the second suction nozzle 15 which is located in the position next to the first suction nozzle 15 and picks up an electronic component next moves toward the position suitable for picking the electronic component and moves in the X and Y directions.

The CPU 90 outputs a signal to the nozzle vertical movement motor 51, and simultaneously outputs a signal to pick the electronic component by the second suction nozzle 15 next to the first suction nozzle 15. In detail, the CPU 90 outputs a signal to locate the second suction nozzle 15 in the position above the component feeding portion of the component feeding unit 3 supplying the electronic component to be picked up and to locate the second suction nozzle 15 in the pickup position of the nozzle support body 31. Then, by the driving of each of linear motors 9 and 14 and the rotation of the nozzle rotation motor 33 based on the signal, the second suction nozzle 15 moves to above the component feeding unit 3 supplying the electronic component and rotates to the same pickup position as the pickup position where the first suction nozzle 15 is located previously. In parallel with the rotation of the nozzle support body 31 by the rotation of the nozzle rotation motor 33, the nozzle selection motor 71 rotates based on the signal from the CPU 90, and by this rotation the nozzle support member 62 rotates. The rotation of the nozzle support member 62 makes the first support piece 63 rotate in the similar manner to the case of the first suction nozzle described above, and the first support piece 63 stops at the position corresponding to the second suction nozzle 15 to be vertically moved this time.

Then, in the similar manner to the case of the first suction nozzle 15, when the nozzle vertical movement motor 51 rotates, and the solenoid valve 82 corresponding to the second suction nozzle 15 operates based on the signal from the CPU 90, the path switch body 85 rises, the vacuum leading path 88 and the nozzle connection path 87 are connected with each other, the inner path of the suction nozzle 15 is connected with the vacuum source 47 through the nozzle axis path 100, the nozzle connection path 87, the vacuum leading path 88, and the switch valve 49A switched to the suction side, and the suction nozzle 15 keeps holding the electronic component by vacuum suction.

After then, in a case where the electronic components can be picked up in sequence by the mounting head 16, a multiple sequential pickup is performed (the electronic components D are sequentially picked up as many as possible) by using each of the remaining suction nozzles selected from twelve suction nozzles 15 provided on the nozzle support body 31, that is, by using each of the remaining suction nozzles selected from the suction nozzles from third to twelfth ones. That is, the electronic components supplied at the component feeding units 3 for the remaining suction nozzles 15 are sequentially picked up by the suction nozzles 15, by the vertical movement of each of the suction nozzles 15 performed when the nozzle support body 32 stops while intermittently rotating by the rotation of the nozzle rotation motor 33.

Then, in this electronic component pickup operation by each of the suction nozzles 15, the line sensor unit 37 detects the presence or absence and the attached posture of the electronic component. In detail, the light receiving unit 46 of the line sensor unit 37 is provided in the position shifted by, for example, 45 degrees from the pickup position 101 shown in Fig. 8. When the suction nozzle 15 holding the electronic component passes the detection position 102 shown in Fig. 8 during the intermittent rotation of the nozzle supporting body 32 in the arrow direction, the line sensor unit 37 detects the presence or absence and the attached posture of the electronic component at the lower end of the suction nozzle 15 for all the electronic components by rotating the mounting head 16 one time as described above.

Then, in a case where there is an electronic component detected as being attached to the suction nozzle 15 at its wrong surface, i.e., with standing or slanting, an individual discharge (collection) operation where the mounting head 16 and the suction nozzle 15 moves to the position above an collection box 79 and drops the electronic component D therein is performed for each of the electronic components before the recognition and the mounting of the electronic component.

In detail, the CPU 90 forms a state of air blow from the air supply source 48 by opening the open-close valve 49B before it switches the air switch valve 80 (the electromagnet 83 of the solenoid valve 82) corresponding to the suction nozzle 15 holding the electronic component which the line sensor unit 37 detects as being attached with wrong posture switches from the air suction side to the air blow side by electrical non-conduction. Then, the CPU 90 switches the air switch valve 80 to the air blow side when the suction nozzle 15 holding the electronic component starts lowering, and breaks the vacuum of the suction nozzle 15 by air from the air supply source 48 through the open-close valve 49B, thereby dropping the electronic component D in the collection box 79 to complete the individual discharge (collection) operation. In detail, the air from the air supply source 48 is blown in the inner path of the suction nozzle 15 through the air blow path 86, the nozzle connection path 87, and the nozzle axis path 100, and blown to the outside of the suction nozzle 15, thereby dropping the electronic component D to complete the individual discharge (collection) operation. At this time, taking account of the safety of the component when mounted, air blow pressure from the suction nozzle 15 is low since the path from the open-close valve 49B to the air switch valve 80 is not closed.

Then, the CPU 90 provides electrical conduction to the air switch valve 80 (the electromagnet 83 of the solenoid valve 82) corresponding to the suction nozzle 15 after this individual discharge operation, in order to switch the valve 80 from the air blow side to the air suction side. The CPU 90 further outputs a signal for rotating the nozzle supporting body 32 by 30 degrees to the nozzle rotation motor 33 so that the suction nozzle 15 passes the detection position 102 shown in Fig. 8, and makes the line sensor unit 37 detect the presence or absence of the electronic component at the lower end of the suction nozzle 15 again. Then, when the line sensor unit 37 detects the electronic component held by the suction nozzle 15, the CPU 90 checks whether or not there is the next (other) electronic component to be individually discharged. In the case where there is the component to be discharged, the same individual discharge operation as above is performed to that component. In the case where there is no component held by the suction nozzle 15, the CPU 90 switches the air switch valve 80 (the electromagnet 83 of the solenoid valve 82) corresponding to this suction nozzle 15 from the air suction side to the air blow side. This prevents the suction nozzle 15 not holding the electronic component from performing vacuum suction in vain.

Then, the component recognition camera 89 takes an image of the electronic component and the recognition processing device 91 performs the component recognition operation such as recognition processing after all the individual discharge operations are completed, or the component recognition operation is performed when there is no electronic component detected as wrong in attached posture, and the mounting operation of the electronic component on the printed board P is performed.

In detail, the CPU 90 controls the linear motors 9 and 14 so as to move the suction nozzle 15 to the position of mounting coordinates on the printed board P positioned on the positioning portion 5, taking account of the recognition processing result received from the recognition processing device 91. The beam 8 moves in the Y direction along the pair of guides 10 by the linear motor 9, and the mounting head body 7 moves in the X direction along the guide 13 by linear motor 14, both the linear motor 9 and the linear motor 14 being driven by the drive circuit 95. The CPU 90 controls the nozzle rotation motor 33, the head vertical movement motor 26, and the nozzle vertical movement motor 51 to mount the electronic component on the printed board P.

When the electronic component is to be mounted, the corresponding air switch valve 80 is switched to the air blow side when the suction nozzle 15 holding the electronic component by suction starts lowering, and the vacuum suction of the suction nozzle 15 is broken by air from the air supply source 48 through the open-close valve 49B, and the electronic component is mounted on the printed board P. In detail, when the suction nozzle 15 lowers, the solenoid valve 82 corresponding to the suction nozzle 15 is switched from the electrical conduction state to the electrical non-conduction state based on a signal from the CPU 90, the vacuum source 47 is disconnected to stop the vacuum suction operation of the suction nozzle 15, the air from the air supply source 48 is blown in the inner path of the suction nozzle 15 through the air blow path 86 and the nozzle connection path 87, and the electronic component is mounted on the printed board P.

When the pickup operation of the electronic component by the first suction nozzle 15 is completed as described above, the CPU 90 outputs a signal to the nozzle vertical movement motor 51. Based on this signal, the nozzle vertical movement motor 51 rotates in the direction for raising the first suction nozzle 15, the ball screw 52 rotates, and the vertical movement body 53 rises to the predetermined height, i.e. the height before it lowers.

Hereafter, based on the flow chart of Fig. 17, description will be given on a relation between the rising of the suction nozzle 15 and timing to start the movement of the beam 8 and the mounting head body 7 in the Y direction and in the X direction respectively driven by the linear motors 9 and 14 (X and Y axes start timing) during the rising of the nozzle 15, in the mounting operation of the electronic component by the suction nozzle 15.

At this time, the CPU 90 calculates the height (position) H1 of the lower surface of the suction nozzle (NL axis) 15 where the lower surface of the suction nozzle 15 does not contact the other structure components such as the electronic component already mounted on the printed board P, and calculates the distance L1 from the original position of the suction nozzle 15 before it starts lowering to the height position H1.

Then, the CPU 90 subtracts the safe distance L2 from the structure components from the distance L1 to obtain the distance L3, the safe distance L2 being set and stored in the RAM 92 in advance.

Then, in the same manner as when the suction nozzle 15 rises in the electronic component pickup operation, the CPU 90 calculates the distance Ln of the rising of the suction nozzle (NL axis) at its rising speed during the start delay time (X and Y axes start delay) tX of the linear motors 9 and 14 for moving the suction nozzle 15, that is, the mounting head 7 in the X and Y directions, the start delay time tX being stored in the RAM 92.

Then, the CPU 90 determines the position obtained by adding the distance Ln to the distance L3 which is from the original point of the suction nozzle 15 to the lower side, as the start timing of the linear motors 9 and 14 (X and Y axes start timing), that is, the time point of outputting an operation signal for moving the linear motors 9 and 14. from the CPU 90.

While the suction nozzle 15 is rising, the CPU 90 observes the position of the lower surface of the suction nozzle 15 based on the rising distance of the suction nozzle 15. When the CPU 90 recognizes that the lower surface of the suction nozzle 15 passes the position (L3+Ln), the CPU 90 outputs a signal to the linear motors 9 and 14 through the interface 94 and the drive circuit 95. Based on this signal, the linear motors 9 and 14 starts operating (X and Y axes start), the beam 8 and the mounting head body 7 move in the Y direction and the X direction respectively, and thus the first suction nozzle 15 moves in the X and Y directions.

In this manner, when the suction nozzle 15 is to rise in the mounting operation of the electronic component, the CPU 90 determines the position of the suction nozzle 15 for starting the linear motors 9 and 14 during the rising of the nozzle 15, taking account of the start delay time of the linear motors 9 and 14 for moving the suction nozzle 15 in the X and Y directions, that is, the time (X and Y axes start delay) tX from the time when the CPU 90 outputs an operation signal for the linear motors 9 and 14 until the time when the linear motors 9 and 14 actually start operating, that is stored in the RAM 92. This realizes the earlier timing to start the movement of the linear motors 9 and 14, that is, the earlier timing to start the movement of the X and Y axes during the rising of the suction nozzle 15, and further the earlier timing to start the next mounting of the electronic component by the next suction nozzle 15.

As a result of this, the mounting time of each of the electronic components can be minimized.

In the above-described embodiment, the time tnl, the moving distance Xtol, and the moving distance Ln are calculated based on the lowering speed and the rising speed of the suction nozzle 15 and the moving speeds of the beam 8 and the mounting head body 7 as the X and Y axes. However, it is possible to calculate the time tnl, the moving distance Xtol, and the moving distance Ln based on the accelerations of the lowering speed and the rising speed of the suction nozzle 15 and the accelerations of the moving speeds of the beam 8 and the mounting head body 7 as the X and Y axes, or based on both the speeds and the accelerations.
Although the particular embodiment of the invention has been disclosed in detail, it will be recognized that variations or modifications of the disclosed apparatus are possible based on the disclosure for those skilled in the art and lie within the scope of the present invention.

## Claims

1. An electronic component mounting apparatus comprising:
a component feeding unit supplying an electronic component;
a suction nozzle picking up the electronic component supplied from the component feeding unit by suction;
a horizontal movement mechanism comprising a first axis and moving the suction nozzle horizontally along the first axis;
a vertical movement mechanism comprising a second axis and moving the suction nozzle vertically along the second axis; and
a control device starting a horizontal movement of the suction nozzle by the horizontal movement mechanism after a delay period in which the horizontal movement of the suction nozzle is halted after the horizontal movement mechanism is activated while the suction nozzle is rising after the electronic component is picked up by the suction nozzle or after the electronic component picked up by the suction nozzle is mounted on a printed board.

2. The electronic component mounting apparatus of claim 1, further comprising a memory storing size data of the electronic component, height data of the component feeding unit and height data of an electronic component mounted on the printed board.

3. The electronic component mounting apparatus of claim 1, wherein the control device operates so that the horizontal movement mechanism is activated when the suction nozzle rises to a first vertical level, and the delay period starts when the suction nozzle reaches the first vertical level and ends when the suction nozzle reaches a second vertical level which provides a horizontal pass of the suction nozzle without interference from the component feeding unit or other electronic component mounted on the printed board.

4. The electronic component mounting apparatus of claim 3, wherein the control device calculates the second vertical level based on size data of the electronic component, height data of the component feeding unit and height data of the electronic component mounted on the printed board.

5. An electronic component mounting apparatus comprising:
a component feeding unit supplying an electronic component;
a suction nozzle picking up the electronic component supplied from the component feeding unit by suction and mounting the electronic component held by the suction nozzle on a printed board;
a horizontal movement mechanism comprising a first axis and moving the suction nozzle horizontally along the first axis;
a vertical movement mechanism comprising a second axis and moving the suction nozzle vertically along the second axis; and
a control device starting a vertical downward movement of the suction nozzle by the vertical movement mechanism while moving the section nozzle horizontally by the horizontal movement mechanism so that when the suction nozzle reaches a horizontal position for electronic component pickup or electronic component mounting the suction nozzle reaches a vertical level which provides a horizontal pass of the suction nozzle without interference from the component feeding unit or other electronic component mounted on the printed board wherein the control device provides a delay period in which the vertical movement of the suction nozzle is halted after the vertical movement mechanism is activated for the vertical downward movement.

6. The electronic component mounting apparatus of claim 5, wherein the control device calculates the vertical level based on size data of the electronic component, height data of the component feeding unit and height data of the electronic component mounted on the printed board.

7. The electronic component mounting apparatus of claim 6, wherein the control device calculates the vertical level based on size data of the electronic component, height data of the component feeding unit, and height data of the electronic component mounted on the printed board.

## Patentansprüche

1. Einrichtung zur Montage von elektronischen Bauteilen, aufweisend:
eine Bauteilzubringereinheit, die ein elektronisches Bauteil zuführt;
eine Saugdüse, die das elektronische Bauelement, das von der Bauteilzubringereinheit zugeführt wird, durch Ansaugen aufnimmt;
einen Horizontalbewegungsmechanismus, der eine erste Achse aufweist und die Saugdüse entlang der ersten Achse horizontal bewegt;
einen Vertikalbewegungsmechanismus, der eine zweite Achse aufweist und die Saugdüse entlang der zweiten Achse vertikal bewegt; und
eine Steuervorrichtung, die eine horizontale Bewegung der Saugdüse durch den Horizontalbewegungsmechanismus nach einer Verzögerungsperiode startet, in welcher die horizontale Bewegung der Saugdüse nach der Aktivierung des Horizontalbewegungsmechanismus angehalten wird, während die Saugdüse nach der Aufnahme des elektronischen Bauelements durch die Saugdüse oder nach dem Montieren des von der Saugdüse aufgenommenen elektronischen Bauteils auf einer Leiterplatte ansteigt.

2. Einrichtung zur Montage von elektronischen Bauteilen nach Anspruch 1, ferner aufweisend einen Speicher, der Größendaten des elektronischen Bauteils, Höhendaten der Bauteilzubringereinheit und Höhendaten eines auf der Leiterplatte montierten elektronischen Bauteils speichert.

3. Einrichtung zur Montage von elektronischen Bauteilen nach Anspruch 1, wobei die Steuervorrichtung so funktioniert, dass der Horizontalbewegungsmechanismus aktiviert wird, wenn die Saugdüse auf eine erste vertikale Ebene ansteigt, und die Verzögerungsperiode beginnt, wenn die Saugdüse die erste vertikale Ebene erreicht, und endet, wenn die Saugdüse eine zweite vertikale Ebene erreicht, welche einen horizontalen Durchgang der Saugdüse ohne Störung von der Bauteilzubringereinheit oder einem anderen auf der Leiterplatte montierten elektronischen Bauteil bereitstellt.

4. Einrichtung zur Montage von elektronischen Bauteilen nach Anspruch 3, wobei die Steuervorrichtung die zweite vertikale Ebene basierend auf Größendaten des elektronischen Bauteils, Höhendaten der Bauteilzubringereinheit und Höhendaten eines auf der Leiterplatte montierten elektronischen Bauteils berechnet.

5. Einrichtung zur Montage von elektronischen Bauteilen, aufweisend:
eine Bauteilzubringereinheit, die ein elektronisches Bauteil zuführt;
eine Saugdüse, die das elektronische Bauteil das durch die Bauteilzubringereinheit zugeführt wird, durch Ansaugen aufnimmt und das von der Saugdüse gehaltene elektronische Bauteil auf einer Leiterplatte montiert;
einen Horizontalbewegungsmechanismus, der eine erste Achse aufweist und die Saugdüse entlang der ersten Achse horizontal bewegt;
einen Vertikalbewegungsmechanismus, der eine zweite Achse aufweist und die Saugdüse entlang der zweiten Achse vertikal bewegt; und
eine Steuervorrichtung, die eine vertikale Abwärtsbewegung der Saugdüse durch den Vertikalbewegungsmechanismus startet, während die Saugdüse durch den Horizontalbewegungsmechanismus horizontal bewegt wird, so dass, wenn die Saugdüse eine horizontale Position zur Aufnahme eines elektronischen Bauteils oder zur Montage eines elektronischen Bauteils erreicht, die Saugdüse eine vertikale Ebene erreicht, welche einen horizontalen Durchgang der Saugdüse ohne Störung von der Bauteilzubringereinheit oder einem anderen auf der Leiterplatte montierten elektronischen Bauteil bereitstellt, wobei die Steuervorrichtung eine Verzögerungsperiode bereitstellt, in welcher die vertikale Bewegung der Saugdüse nach der Aktivierung des Vertikalbewegungsmechanismus für die vertikale Abwärtsbewegung angehalten wird.

6. Einrichtung zur Montage von elektronischen Bauteilen nach Anspruch 5, wobei die Steuervorrichtung die vertikale Ebene basierend auf Größendaten des elektronischen Bauteils, Höhendaten der Bauteilzubringereinheit und Höhendaten des auf der Leiterplatte montierten elektronischen Bauteils berechnet.

7. Einrichtung zur Montage von elektronischen Bauteilen nach Anspruch 6, wobei die Steuervorrichtung die vertikale Ebene basierend auf Größendaten des elektronischen Bauteils, Höhendaten der Bauteilzubringereinheit und Höhendaten des auf die Leiterplatte montierten elektronischen Bauteils berechnet.

## Revendications

1. Appareil de montage de composants électroniques comprenant :
une unité d'alimentation en composant fournissant un composant électronique ;
une buse d'aspiration prélevant par aspiration le composant électronique fourni par l'unité d'alimentation en composant ;
un mécanisme de mouvement horizontal comprenant un premier axe et déplaçant la buse d'aspiration horizontalement le long du premier axe ;
un mécanisme de mouvement vertical comprenant un second axe et déplaçant la buse d'aspiration verticalement le long du second axe ; et
un dispositif de commande démarrant un mouvement horizontal de la buse d'aspiration par le biais du mécanisme de mouvement horizontal après une période de retard au cours de laquelle le mouvement horizontal de la buse d'aspiration est arrêté après que le mécanisme de mouvement horizontal a été activé alors que la buse d'aspiration s'élève après que le composant électronique a été prélevé par la buse d'aspiration ou après que le composant électronique prélevé par la buse d'aspiration a été monté sur une carte de circuit imprimé.

2. Appareil de montage de composants électroniques selon la revendication 1, comprenant en outre une mémoire stockant des données de taille du composant électronique, des données de hauteur de l'unité d'alimentation en composant et des données de hauteur d'un composant électronique monté sur la carte de circuit imprimé.

3. Appareil de montage de composants électroniques selon la revendication 1, dans lequel le dispositif de commande fonctionne de sorte que le mécanisme de mouvement horizontal soit activé lorsque la buse d'aspiration s'élève à un premier niveau vertical, et la période de retard démarre lorsque la buse d'aspiration atteint le premier niveau vertical et s'arrête lorsque la buse d'aspiration atteint un second niveau vertical qui procure un passage horizontal de la buse d'aspiration sans interférence de l'unité d'alimentation en composant ou d'un autre composant électronique monté sur la carte de circuit imprimé.

4. Appareil de montage de composants électroniques selon la revendication 3, dans lequel le dispositif de commande calcule le second niveau vertical sur la base des données de taille du composant électronique, des données de hauteur de l'unité d'alimentation en composant et des données de hauteur du composant électronique monté sur la carte de circuit imprimé.

5. Appareil de montage de composants électroniques comprenant :
une unité d'alimentation en composant fournissant un composant électronique ;
une buse d'aspiration prélevant par aspiration le composant électronique fourni par l'unité d'alimentation en composant et montant le composant électronique, tenu par la buse d'aspiration, sur une carte de circuit imprimé ;
un mécanisme de mouvement horizontal comprenant un premier axe et déplaçant la buse d'aspiration horizontalement le long du premier axe ;
un mécanisme de mouvement vertical comprenant un second axe et déplaçant la buse d'aspiration verticalement le long du second axe ; et
un dispositif de commande démarrant un mouvement de descente verticale de la buse d'aspiration par le biais du mécanisme de mouvement vertical alors que la buse d'aspiration est déplacée horizontalement par le mécanisme de mouvement horizontal de sorte que, lorsque la buse d'aspiration atteint une position horizontale pour le prélèvement d'un composant électronique ou le montage d'un composant électronique, la buse d'aspiration atteigne un niveau vertical qui procure un passage horizontal de la buse d'aspiration sans interférence de l'unité d'alimentation en composant ou d'un autre composant électronique monté sur la carte de circuit imprimé, le dispositif de commande fournissant une période de retard au cours de laquelle le mouvement vertical de la buse d'aspiration est arrêté après que le mécanisme de mouvement vertical a été activé pour le mouvement de descente verticale.

6. Appareil de montage de composants électroniques selon la revendication 5, dans lequel le dispositif de commande calcule le niveau vertical sur la base de données de taille du composant électronique, de données de hauteur de l'unité d'alimentation en composant et de données de hauteur du composant électronique monté sur la carte de circuit imprimé.

7. Appareil de montage de composants électroniques selon la revendication 6, dans lequel le dispositif de commande calcule le niveau vertical sur la base de données de taille du composant électronique, de données de hauteur de l'unité d'alimentation en composant et de données de hauteur du composant électronique monté sur la carte de circuit imprimé.
